# EUROPEAN PATENT APPLICATION

(11) **EP 4 632 410 A1**
(43) Date of publication of application: **15.10.2025**
(21) Application number: 23916426.2
(22) Date of filing: 13.12.2023
(51) Int. Cl.: G01R 31/392, G01R 31/396, G01R 31/52, G01R 31/385, G01R 19/30, G01R 19/12, G01R 31/367

(54) **BATTERY ABNORMALITY DIAGNOSIS DEVICE AND METHOD FOR OPERATING SAME**

(30) Priority: 13.01.2023 KR 20230005734
(71) Applicant: LG Energy Solution, Ltd., Seoul 07335 (KR)
(72) Inventor: YOON, Du Seong, Daejeon 34122 (KR); LEE, Bom Jin, Daejeon 34122 (KR); LEE, Kang Wook, Daejeon 34122 (KR); LEE, Jeong Hwan, Daejeon 34122 (KR); KIM, Won Kyung, Daejeon 34122 (KR)
(74) Representative: BCKIP Part mbB
(86) International application number: PCT/KR2023/020569
(87) International publication number: WO 2024/150943

(57) **Abstract**

A battery abnormality diagnosis apparatus according to an embodiment disclosed herein includes a data obtaining unit configured to obtain a plurality of discharge profiles of a battery unit for a designated period of time, a data processing unit configured to obtain a plurality of voltage-capacity profiles indicating a voltage change amount-capacity change amount of the battery unit, based on the discharge profiles, a peak value obtaining unit configured to obtain peak values of the battery unit for the designated period of time, based on the plurality of voltage-capacity profiles, and a diagnosing unit configured to determine a possibility of ignition of the battery unit, based on the peak values, in which the peak values are peak values close to a designated capacity among two or more candidate peak values identified from each of the plurality of voltage-capacity profiles.

## Description

### [TECHNICAL FIELD]

### CROSS-REFERENCE TO RELATED APPLICATION

This application claims priority to and the benefit of Korean Patent Application No. 10-2023-0005734 filed in the Korean Intellectual Property Office on January 13, 2023, the entire content of which is incorporated herein by reference.

### TECHNICAL FIELD

Embodiments disclosed herein relate to a battery abnormality diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

### [DISCLOSURE]

### [TECHNICAL PROBLEM]

When a short circuit or a failure of another type occurs inside a battery, the possibility of damage to devices (e.g., EV, ESS) including the battery may increase.

Accordingly, there is a need for a scheme to reduce the possibility of damage to devices including a battery by detecting an abnormal state of the battery.

Technical problems of the embodiments disclosed herein are not limited to the above-described technical problems, and other unmentioned technical problems would be clearly understood by one of ordinary skill in the art from the following description.

### [TECHNICAL SOLUTION]

A battery abnormality diagnosis apparatus according to an embodiment disclosed herein includes a data obtaining unit configured to obtain a plurality of discharge profiles of a battery unit for a designated period of time, a data processing unit configured to obtain a plurality of voltage-capacity profiles indicating a voltage change amount-capacity change amount of the battery unit, based on the discharge profiles, a peak value obtaining unit configured to obtain peak values of the battery unit for the designated period of time, based on the plurality of voltage-capacity profiles, and a diagnosing unit configured to determine a possibility of ignition of the battery unit, based on the peak values, in which the peak values are peak values close to a designated capacity among two or more candidate peak values identified from each of the plurality of voltage-capacity profiles.

An operating method of a battery abnormality diagnosis apparatus according to an embodiment disclosed herein includes obtaining a plurality of discharge profiles of a battery unit for a designated period of time, obtaining a plurality of voltage-capacity profiles indicating a voltage change amount-capacity change amount of the battery unit, based on the discharge profiles, obtaining peak values of the battery unit for the designated period of time, based on the plurality of voltage-capacity profiles, and determining a possibility of ignition of the battery unit, based on the peak values, in which the peak values are peak values close to a designated capacity among two or more candidate peak values identified from each of the plurality of voltage-capacity profiles.

### [ADVANTAGEOUS EFFECTS]

A battery abnormality diagnosis apparatus and an operating method thereof according to various embodiments disclosed herein may detect a possibility of battery ignition.

A battery abnormality diagnosis apparatus and an operating method thereof according to various embodiments disclosed herein may provide information about a battery detected as being likely to ignite to a user.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

### [DESCRIPTION OF DRAWINGS]

FIG. 1 is a block diagram of a battery abnormality diagnosis apparatus according to an embodiment of the present disclosure.
FIG. 2 illustrates an example of a voltage-capacity profile according to an embodiment of the present disclosure.
FIG. 3 illustrates peak values for a designated period according to an embodiment of the present disclosure.
FIG. 4 illustrates an example of a polynomial of peak values according to an embodiment of the present disclosure.
FIG. 5 illustrates another example of a polynomial of peak values according to an embodiment of the present disclosure.
FIG. 6 is a flowchart showing an operating method of a battery abnormality diagnosis apparatus according to an embodiment of the present disclosure.

With regard to the description of the drawings, similar reference numerals may be used to refer to similar or related components.

### [MODE FOR INVENTION]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

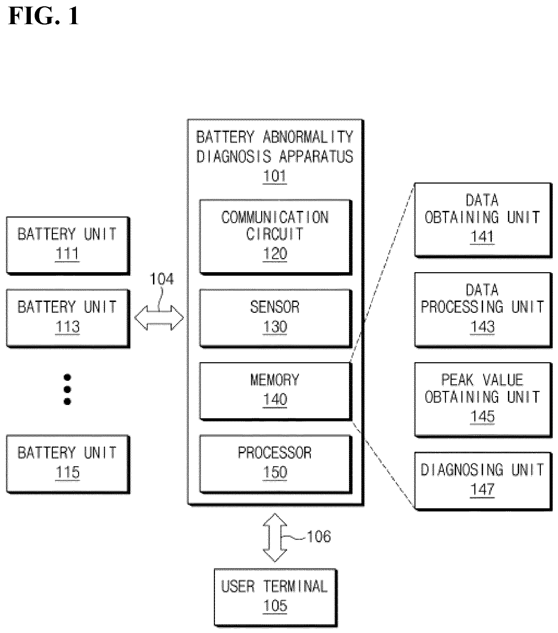

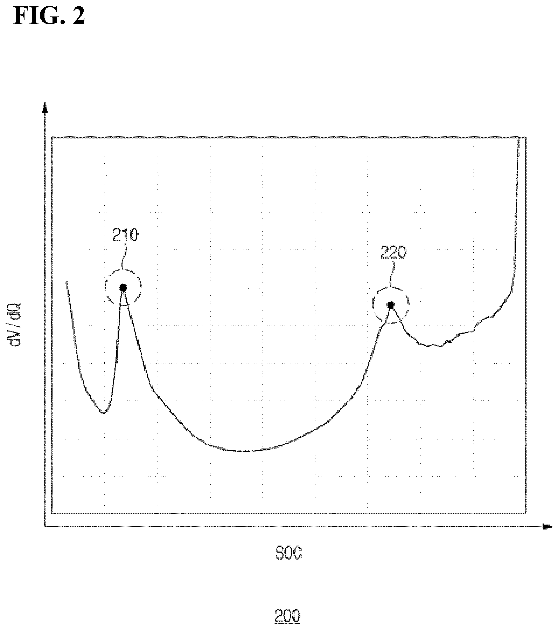

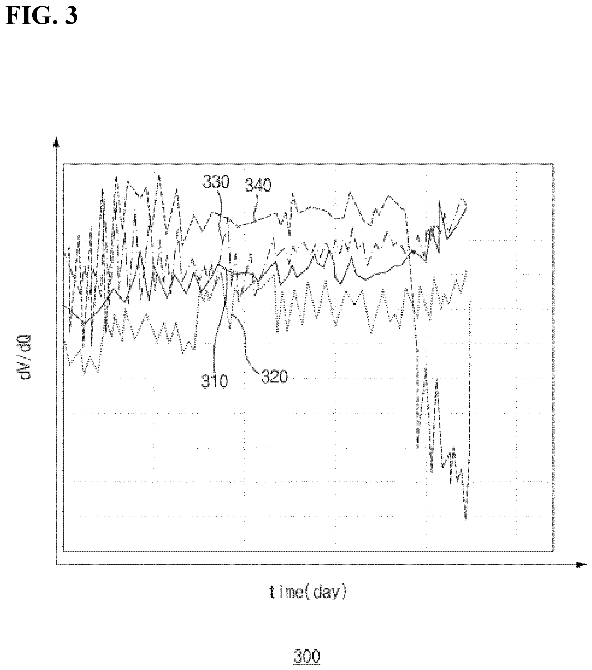

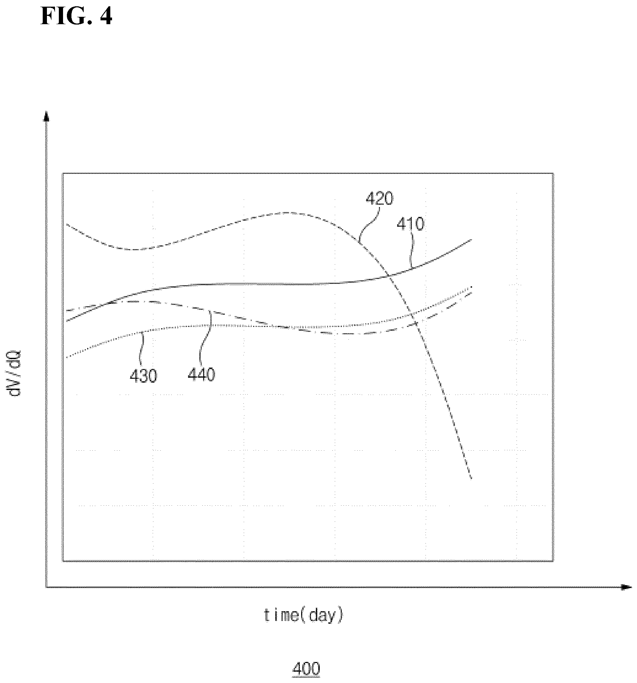

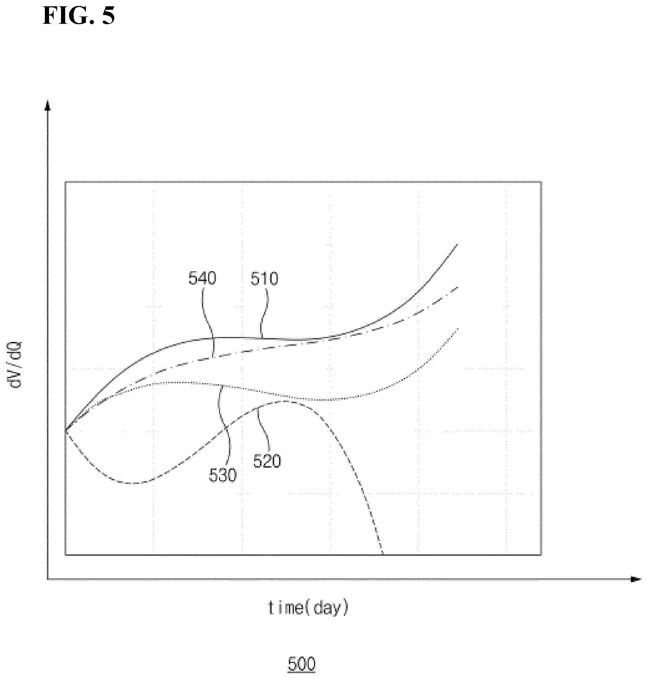

FIG. 1 is a block diagram of a battery abnormality diagnosis apparatus 101 according to an embodiment of the present disclosure. FIG. 2 illustrates an example of a voltage-capacity profile according to an embodiment of the present disclosure. FIG. 3 illustrates peak values for a designated period according to an embodiment of the present disclosure. FIG. 4 illustrates an example of a polynomial of peak values according to an embodiment of the present disclosure. FIG. 5 illustrates another example of a polynomial of peak values according to an embodiment of the present disclosure.

Referring to FIG. 1, a battery abnormality diagnosis apparatus 101 may be wiredly and/or wirelessly connected to battery units 111, 113, and 115 and a user terminal 105.

In an embodiment, connection 104 between the battery abnormality diagnosis apparatus 101 and the battery units 111, 113, and 115 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection 104 between the battery abnormality diagnosis apparatus 101 and the battery units 111, 113, and 115 may be connection using a device-to-device communication scheme (e.g., a bus, a general-purpose input and output (GPIO), a serial peripheral interface (SPI), or a mobile industry processor interface (MIPI)).

In an embodiment, connection 106 between the battery abnormality diagnosis apparatus 101 and the user terminal 105 may be communication connection through a wired and/or wireless network.

In an embodiment, each of the one or more battery units 111, 113, and 115 may be a battery cell, a battery module, a battery pack, or a battery rack. In an embodiment, each of the battery units 111, 113, and 115 may be amounted on a mobile device (e.g., a mobile phone, a laptop computer, a smart phone, a smart pad), en electric vehicle (e.g., an electric vehicle (EV), a hybrid EV (HEV), a plug-in HEV (PHEV), a fuel cell EV (FCEV)), an energy storage system (ESS), or a battery swapping system (BSS). In this case, the battery abnormality diagnosis apparatus 101 may be included in a mobile device (e.g., a cellular phone, a laptop computer, a smart phone, a smart pad), an electric vehicle (e.g., EV, HEV, PHEV, FCEV), an energy storage system (ESS), or a battery swapping system (BSS).

In an embodiment, the user terminal 105 may be a mobile device (e.g., a mobile phone, a laptop computer, a smart phone, a smart pad), or a personal computer (PC).

In an embodiment, the battery abnormality diagnosis apparatus 101 may include a communication circuit 120, a sensor 130, a memory 140, and a processor 150. According to an embodiment, the battery abnormality diagnosis apparatus 101 shown in FIG. 2 may further include at least one component (e.g., a display, an input device, or an output device) in addition to components shown in FIG. 2.

In an embodiment, the communication circuit 120 may establish a wired communication channel and/or a wireless communication channel between the battery abnormality diagnosis apparatus 101 and the battery units 111, 113, and 115 and/or the user terminal 105, and transmit and receive data to and from the battery units 111, 113, and 115 and/or the user terminal 105 through the established communication channel.

In an embodiment, the sensor 130 may obtain values related to states of the battery units 111, 113, and 115 of the electronic device 103. In an embodiment, the values related to the states may indicate one or more values of voltages, currents, resistances, SOC, states of health (SOH), or temperatures of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery abnormality diagnosis apparatus 101. For example, the data may include software (or an instruction related thereto), input data, or output data. In an embodiment, the instruction, when executed by the processor 150, may cause the battery abnormality diagnosis apparatus 101 to perform operations defined by the instruction.

In an embodiment, the memory 140 may include one or more software (e.g., an obtaining unit 141, an identifying unit 143, a diagnosing unit 145, and an abnormality processing unit 147).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., a data processing unit 143, a peak value obtaining unit 145, and a diagnosing unit 147) to control at least one other component (e.g., a hardware or software component) of the battery diagnosis apparatus 101 connected to the processor 150 and perform various data processing or operations.

Hereinbelow, referring to FIGS. 2 to 5, a description will be made of a method, performed by the battery abnormality diagnosis apparatus 101, of diagnosing abnormality of the battery units 111, 113, and 115 through the data obtaining unit 141, the data processing unit 143, the peak value obtaining unit 145, and the diagnosing unit 147.

In an embodiment, the data obtaining unit 141 may obtain discharge profiles of the plurality of battery units 111, 113, and 115. In an embodiment, the discharge profile may indicate a relationship between a voltage (e.g., an open circuit voltage (OCV)) and an SOC (or charge, current) of a battery unit (e.g., the battery unit 111).

In an embodiment, the data obtaining unit 141 may obtain the discharge profiles from the plurality of respective battery unit 111, 113, and 115 connected through a wired and/or wireless network. In another embodiment, the data obtaining unit 141 may obtain voltages, currents, temperatures of the plurality of battery unit 111, 113, and 115, or a combination thereof using the sensor 130, and generate the discharge profiles based on the obtained voltages, currents, temperatures, or combination thereof.

In an embodiment, the data obtaining unit 141 may obtain a plurality of discharge profiles for each of the plurality of battery units 111, 113, and 115, for a designated period of time. Herein, the designated period of time may be one or more days. The plurality of discharge profiles of each of the plurality of battery units 111, 113, and 115 may be obtained for different periods. For example, the plurality of discharge profiles of each of the plurality of battery units 111, 113, and 115 may be obtained on different dates.

In an embodiment, the data obtaining unit 141 may obtain a plurality of discharge profiles for each of the plurality of battery units 111, 113, and 115 according to a discharge profile obtaining cycle for the designated period of time. For example, when the designated period of time is 30 days and the discharge profile obtaining cycle is one day, the data obtaining unit 141 may obtain 30 discharge profiles for each of the plurality of battery units 111, 113, and 115.

In an embodiment, the data processing unit 143 may obtain a voltage-capacity profile indicating a relationship between a voltage change amount and a capacity change amount of the battery unit (e.g., the battery unit 111) based on the discharge profile. In an embodiment, the data processing unit 143 may obtain the voltage-capacity profile by differentiating the discharge profile of the battery unit (e.g., the battery unit 111). Herein, the data processing unit 143 may obtain the voltage-capacity profile by obtaining a micro-change amount dV of a voltage V with respect to a micro-change amount dQ of a charge Q from the discharge profile of the battery unit (e.g., the battery unit 111).

In an embodiment, the data processing unit 143 may obtain the voltage-capacity profile by obtaining a differential value (dV/dQ) for every SOC periods. FIG. 2 illustrates a voltage-capacity profile 200 obtained by the data processing unit 143 from a discharge profile obtained at a specific point in time.

In an embodiment, the data obtaining unit 143 may obtain the voltage-capacity profile for each of the plurality of discharge profiles of each of the plurality of battery units 111, 113, and 115. In an embodiment, the data processing unit 143 may process the voltage-capacity profile for each discharge profile. Thus, when 30 discharge profiles are obtained for each of the plurality of battery units 111, 113, and 115, the data processing unit 143 may obtain 30 voltage-capacity profiles.

In an embodiment, the peak value obtaining unit 145 may obtain the peak values of the battery based on the plurality of voltage-capacity profiles of the battery unit (e.g., the battery unit 111). In an embodiment, the peak values of the battery unit may be obtained from the voltage-capacity profiles based on each of the discharge profiles obtained for the designated period of time. Herein, the peak values may be local maximum values of the voltage-capacity profiles.

In an embodiment, the peak value obtaining unit 145 may obtain one peak value among one or more peak values from each of the plurality of voltage-capacity profiles of the battery unit (e.g., the battery unit 111). For example, when 30 discharge profiles are obtained for each of the plurality of battery units 111, 113, and 115, the peak value obtaining unit 145 may obtain 30 voltage-capacity profiles.

In an embodiment, the peak value obtaining unit 145 may obtain one peak value among the one or more peak values from each of the plurality of voltage-capacity profiles based on a peak value selection criterion. For example, the peak value obtaining unit 145 may obtain one peak value close to a designated capacity among one or more candidate peak values of each of the plurality of voltage-capacity profiles. Herein, the designated capacity may correspond to a capacity with an SOC of 100 %.

Referring to FIG. 2, a voltage-capacity profile 200 may include one or more peak values 210 and 220. The peak value obtaining unit 145 may select a peak value 220 close to an SOC of 100 % among the one or more peak values 210 and 220.

In an embodiment, the diagnosing unit 147 may determine a possibility of ignition of the battery unit (e.g., the battery unit 111) based on peak values.

In an embodiment, the diagnosing unit 147 may determine a polynomial (or coefficients thereof) indicating peak values of the battery unit (e.g., the battery unit 111), based on a regression analysis algorithm. In an embodiment, the diagnosing unit 147 may determine the possibility of ignition of the battery unit (e.g., the battery unit 111) by using the determined polynomial. For example, the designated polynomial may be a third-order equation.

Referring to FIG. 3, lines 310, 320, and 330 may indicate peak values of each of the plurality of battery units 111, 113, and 115 for a designated period of time. In an embodiment, the diagnosing unit 147 may determine polynomials by regressively analyzing the lines 310, 320, and 330. Referring to FIG. 4, lines 410, 420, and 430 may indicate polynomials determined based on the lines 310, 320, and 330.

In an embodiment, the diagnosing unit 147 may modify the polynomial by setting an initial value of the determined polynomial to a designated value. Referring to FIG. 5, lines 510, 520, and 530 may indicate lines after moving the initial values of the lines 410, 420, and 430 to a designated value.

In an embodiment, the diagnosing unit 147 may determine the possibility of ignition of the battery unit (e.g., the battery unit 111) by using the modified polynomial. For example, the designated polynomial may be a third-order equation. Herein, the designated value may be an initial value (e.g., 0) of a reference polynomial. Herein, the reference polynomial may be a polynomial experimentally obtained in advance to determine a possibility of ignition of a battery unit. A line 540 of FIG. 5 may be a line indicating the reference equation. In an embodiment, the line 540 may be obtained from the line 440 indicating a polynomial obtained by regressively analyzing the line 340 indicating peak values of a battery unit not ignited.

In an embodiment, the diagnosing unit 147 may determine that a battery unit (e.g., the battery unit 111) has a high ignition possibility when values for a designated period of time, identified according to the modified equation of the battery unit, are greater than values for the designated period of time, identified according to the reference polynomial. For example, given that the modified polynomial is F1 and the reference polynomial is F2, when F1 - F2 for the designated period of time is 0 or greater, the diagnosing unit 147 may determine that the battery unit has a high ignition possibility. In another example, when there are one or more points in time at which F1 - F2 for the designated period of time is less than 0, the diagnosing unit 147 may determine that the battery unit has a low ignition possibility.

The battery abnormality diagnosis apparatus 101 according to an embodiment described above may detect a possibility of ignition of the battery unit.

In another embodiment, the diagnosing unit 147 may determine a change amount of the peak values for the designated period of time, compare the change amount of the battery unit with the reference change amount to determine the possibility of ignition of the battery unit. Herein, the change amount may be a change amount of peak values from an initial point in time to a current point in time. Herein, the reference change amount may be a change amount experimentally obtained in advance to determine the possibility of ignition of the battery unit. For example, the line 340 of FIG. 3 may be a line indicating the reference change amount.

For example, given that the change amount is V1 and the reference change amount is V2, when V1 - V2 for the designated period of time is 0 or greater, the diagnosing unit 147 may determine that the battery unit has a high ignition possibility. In another example, when there are one or more points in time at which V1 - V2 for the designated period of time is less than 0, the diagnosing unit 147 may determine that the battery unit has a low ignition possibility.

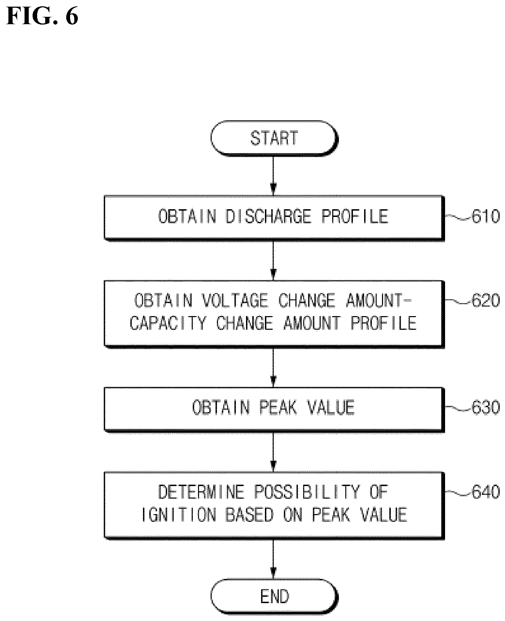

FIG. 6 is a flowchart showing an operating method of the battery abnormality diagnosis apparatus 101 according to an embodiment of the present disclosure. FIG. 6 will be described using components of FIG. 1.

Referring to FIG. 6, in operation 610, the battery abnormality diagnosis apparatus 101 may obtain a discharge profile. In an embodiment, the battery abnormality diagnosis apparatus 101 may obtain a plurality of discharge profiles for each of the plurality of battery units 111, 113, and 115, for a designated period of time. In an embodiment, the discharge profile may indicate a relationship between a voltage (e.g., an OCV) and an SOC (or charge, current) of a battery unit (e.g., the battery unit 111).

In operation 620, the battery abnormality diagnosis apparatus 101 may obtain a voltage change amount-capacity change amount profile. In an embodiment, the battery abnormality diagnosis apparatus 101 may obtain a voltage-capacity profile indicating a relationship between a voltage change amount and a capacity change amount of the battery unit (e.g., the battery unit 111) based on the discharge profile. Herein, the battery abnormality diagnosis apparatus 101 may obtain the voltage-capacity profile by obtaining a micro-change amount dV of a voltage V with respect to a micro-change amount dQ of a charge Q from the discharge profile of the battery unit (e.g., the battery unit 111).

In operation 630, the battery abnormality diagnosis apparatus 101 may obtain a peak value. In an embodiment, the battery abnormality diagnosis apparatus 101 may obtain the peak values of the battery based on the plurality of voltage-capacity profiles of the battery unit (e.g., the battery unit 111). In an embodiment, the peak values of the battery unit may be obtained from the voltage-capacity profiles based on each of the discharge profiles obtained for the designated period of time. Herein, the peak values may be local maximum values of the voltage-capacity profiles.

In operation 640, the battery abnormality diagnosis apparatus 101 may determine a possibility of ignition based on the peak value.

In an embodiment, the battery abnormality diagnosis apparatus 101 may determine a polynomial (or coefficients thereof) indicating peak values of the battery unit (e.g., the battery unit 111), based on a regression analysis algorithm. In an embodiment, the battery abnormality diagnosis apparatus 101 may determine the possibility of ignition of the battery unit (e.g., the battery unit 111) by using the determined polynomial. For example, the designated polynomial may be a third-order equation.

In an embodiment, the battery abnormality diagnosis apparatus 101 may modify the polynomial by setting an initial value of the determined polynomial to a designated value. In an embodiment, the battery abnormality diagnosis apparatus 101 may determine the possibility of ignition of the battery unit (e.g., the battery unit 111) by using the modified polynomial.

In an embodiment, the battery abnormality diagnosis apparatus 101 may determine that a battery unit (e.g., the battery unit 111) has a high ignition possibility when values for a designated period of time, identified according to the modified equation of the battery unit, are greater than values for the designated period of time, identified according to the reference polynomial. For example, given that the modified polynomial is F1 and the reference polynomial is F2, when F1 - F2 for the designated period of time is 0 or greater, the battery abnormality diagnosis apparatus 101 may determine that the battery unit has a high ignition possibility. In another example, when there are one or more points in time at which F1 - F2 for the designated period of time is less than 0, the battery abnormality diagnosis apparatus 101 may determine that the battery unit has a low ignition possibility.

In another embodiment, the battery abnormality diagnosis apparatus 101 may determine a change amount of the peak values for the designated period of time compare the change amount of the battery unit with the reference change amount to determine the possibility of ignition of the battery unit. Herein, the change amount may be a change amount of peak values from an initial point in time to a current point in time.

## Claims

1. A battery abnormality diagnosis apparatus comprising:
a data obtaining unit configured to obtain a plurality of discharge profiles of a battery unit for a designated period of time;
a data processing unit configured to obtain a plurality of voltage-capacity profiles indicating a voltage change amount-capacity change amount of the battery unit, based on the discharge profiles;
a peak value obtaining unit configured to obtain peak values of the battery unit for the designated period of time, based on the plurality of voltage-capacity profiles; and
a diagnosing unit configured to determine a possibility of ignition of the battery unit, based on the peak values,
wherein the peak values are peak values close to a designated capacity among two or more candidate peak values identified from each of the plurality of voltage-capacity profiles.

2. The battery abnormality diagnosis apparatus of claim 1, wherein the diagnosing unit is further configured to:
determine a change amount of the peak values for the designated period of time; and
compare the change amount of the battery unit with a reference change amount to determine the possibility of ignition of the battery unit.

3. The battery abnormality diagnosis apparatus of claim 2, wherein the reference change amount is determined by a change amount of peak values of a reference battery unit.

4. The battery abnormality diagnosis apparatus of claim 1, wherein the diagnosing unit is further configured to:
determine coefficients of a designated polynomial, based on the peak values for the designated period of time; and
determine the possibility of ignition of the battery unit, based on the designated polynomial with the determined coefficients.

5. The battery abnormality diagnosis apparatus of claim 4, wherein the diagnosing unit is further configured to compare the designated polynomial having the determined coefficients for the battery unit with the reference polynomial to determine the possibility of ignition of the battery unit.

6. The battery abnormality diagnosis apparatus of claim 5, wherein the designated polynomial is a third-order equation.

7. The battery abnormality diagnosis apparatus of claim 5, wherein an initial value of the designated polynomial is 0.

8. The battery abnormality diagnosis apparatus of claim 1, wherein the battery unit comprises one of a battery cell, a battery module, a battery pack, or a battery rack.

9. An operating method of a battery abnormality diagnosis apparatus, the operating method comprising:
obtaining a plurality of discharge profiles of a battery unit for a designated period of time;
obtaining a plurality of voltage-capacity profiles indicating a voltage change amount-capacity change amount of the battery unit, based on the discharge profiles;
obtaining peak values of the battery unit for the designated period of time, based on the plurality of voltage-capacity profiles; and
determining a possibility of ignition of the battery unit, based on the peak values,
wherein the peak values are peak values close to a designated capacity among two or more candidate peak values identified from each of the plurality of voltage-capacity profiles.

10. The operating method of claim 9, wherein the determining of the possibility of ignition comprises:
determining a change amount of the peak values for the designated period of time; and
comparing the change amount of the battery unit with a reference change amount to determine the possibility of ignition of the battery unit.

11. The operating method of claim 10, wherein the reference change amount is determined by a change amount of peak values of a reference battery unit.

12. The operating method of claim 9, wherein the determining of the possibility of ignition comprises:
determining a change amount of the peak values for the designated period of time;
determining coefficients of a designated polynomial based on the change amount of the battery unit; and
determining the possibility of ignition of the battery unit, based on the designated polynomial with the determined coefficients.

13. The operating method of claim 12, wherein the determining of the possibility of ignition comprises comparing the designated polynomial having the determined coefficients for the battery unit with the reference polynomial to determine the possibility of ignition of the battery unit.

14. The operating method of claim 13, wherein the designated polynomial is a third-order equation.

15. The operating method of claim 13, wherein an initial value of the designated polynomial is 0.
